(19) Europäisches Patentamt / European Patent Office / Office européen des brevets

(11) **EP 1 739 213 B1**

(12) **EUROPÄISCHE PATENTSCHRIFT**

(45) Veröffentlichungstag und Bekanntmachung des Hinweises auf die Patenterteilung:
**13.04.2011 Patentblatt 2011/15**

(21) Anmeldenummer: **06011539.1**

(22) Anmeldetag: **02.06.2006**

(51) Int Cl.:
*C30B 33/00* (2006.01)    *C30B 33/02* (2006.01)
*C30B 29/40* (2006.01)    *C30B 29/42* (2006.01)

(54) **Vorrichtung und Verfahren zum Tempern von III-V-Wafern sowie getemperte III-V-Halbleitereinkristallwafer**

Apparatus and method for annealing of III-V wafers and annealed III-V semiconductor single crystal wafers

Appareil et procédé de récuit des plaquettes III-V ainsi que des plaquettes monocristallines récuites du semiconducteur type III-V

(84) Benannte Vertragsstaaten:
**DE FR GB**

(30) Priorität: **01.07.2005 DE 102005030851**
**08.07.2005 US 697826 P**

(43) Veröffentlichungstag der Anmeldung:
**03.01.2007 Patentblatt 2007/01**

(73) Patentinhaber: **Freiberger Compound Materials GmbH**
**09599 Freiberg (DE)**

(72) Erfinder:
• **Jurisch, Manfred, Dr.**
**01217 Dresden (DE)**
• **Eichler, Stefan, Dr.**
**01187 Dresden (DE)**
• **Bünger, Thomas**
**09131 Chemnitz (DE)**
• **Weinert, Berndt, Dr.**
**09599 Freiberg (DE)**
• **Börner, Frank, Dr.**
**01069 Dresden (DE)**

(74) Vertreter: **Hofer, Dorothea et al**
**Prüfer & Partner GbR**
**Patentanwälte**
**Sohnckestrasse 12**
**81479 München (DE)**

(56) Entgegenhaltungen:
**EP-A- 0 399 662    EP-A- 1 122 342**

• **PATENT ABSTRACTS OF JAPAN Bd. 1999, Nr. 03, 31. März 1999 (1999-03-31) & JP 10 321540 A (MITSUBISHI ELECTRIC CORP), 4. Dezember 1998 (1998-12-04)**
• **PATENT ABSTRACTS OF JAPAN Bd. 007, Nr. 258 (E-211), 17. November 1983 (1983-11-17) & JP 58 143520 A (TOKYO SHIBAURA DENKI KK), 26. August 1983 (1983-08-26)**
• **BUNGER T ET AL: "Development of a vertical gradient freeze process for low EPD GaAs substrates" MATERIALS SCIENCE AND ENGINEERING B, ELSEVIER SEQUOIA, LAUSANNE, CH, Bd. 80, Nr. 1-3, 22. März 2001 (2001-03-22), Seiten 5-9, XP004234652 ISSN: 0921-5107**
• **DATABASE COMPENDEX [Online] ENGINEERING INFORMATION, INC., NEW YORK, NY, US; BIBERIN V I ET AL: "VLIYANIE TERMOOBRABOTKI NA VYAZKOST' RAZRUSHENIYA MONOKRISTALLOV ARSENIDA GALLIYA." XP002398006 Database accession no. EIX85100144655 & TSVET MET MAR 1985, Nr. 3, März 1985 (1985-03), Seiten 67-68,**
• **PATENT ABSTRACTS OF JAPAN Bd. 1999, Nr. 01, 29. Januar 1999 (1999-01-29) & JP 10 287500 A (HITACHI CABLE LTD), 27. Oktober 1998 (1998-10-27)**
• **PATENT ABSTRACTS OF JAPAN Bd. 1995, Nr. 01, 28. Februar 1995 (1995-02-28) & JP 06 295863 A (JAPAN ENERGY CORP), 21. Oktober 1994 (1994-10-21)**

**Beschreibung**

Die Erfindung bezieht sich auf eine Vorrichtung und ein Verfahren zur Wärmebehandlung (auch Tempern genannt) von III-V-Wafern (auch Substrate genannt) und auf getemperte Wafer bzw. Substrate. Sie betrifft insbesondere genannte Vorrichtung, Verfahren und Wafer auf der Basis von GaAs-Halbleitermaterialien, vor allem von semiisolierendem (SI) GaAs-Wafern, und nach dem VGF- oder dem VB-Verfahren hergestellte GaAs-Wafer. Solche getemperten Wafer, deren elektrische, elektronische und sonstige physikalische Eigenschaften eingestellt werden können, sind insbesondere für die Herstellung aktiver mikroelektronischer Bauelemente auf der Basis von III-V-Halbleitern geeignet.

Bei der Einkristallzüchtung aus der Schmelze durchläuft das erstarrte Material eine ortsabhängige thermische Geschichte, d. h. die effektive Verweilzeit in einem T-Bereich, in dem Ausgleichsvorgänge (z. B. Relaxation von Restspannungen, Homogenisierung) möglich sind, ist für unterschiedliche Kristallbereiche unterschiedlich. Es ist daher allgemeine Praxis, die Einkristalle nach Abschluß des Züchtungsprozesses entweder in der Züchtungsapparatur, vorzugsweise aber in einem separaten Temperofen einer ausgleichenden Wärmebehandlung zu unterziehen. Das Tempern von GaAs-Einkristallen wurde erstmals von RunnsBY et. al. (D. Rumsby, R. M. Wafer, B. Smith, M. Tyjberg, M. R. Brozel, E. J. Foulkes: Tech. Dig. GaAs IC Symp., New York, IEEE, 1983,34.) zur Spannungsrelaxation und zur Homogenisierung der elektrischen Eigenschaften von undotierten, semi-isolierenden LEC-GaAs-Einkristallen eingesetzt. Seither wurden die Kristall-Temperprozeduren systematisch anwendungs- und anwenderspezifisch optimiert und dienen neben der Homogenisierung auch der Kontrolle der Störstellen. Eine Übersicht zum Kristalltempern von GaAs geben u. a. $O_{DA}$ et al. (O. Oda, H. Yamamoto, K. Kainosho, T. Imaizumi, H. Okazaki: Recent developments of bulk III-V materials: annealing and defect control, Inst. Phys. Conf. Ser. No 135, pp 285 - 293, 1993).

Eine weitere Beschreibung zur Herstellung und zu Eigenschaften von kristallgetemperten III-V (Ga As) - Einkristallen wird bei Th. Bünger et al., Materials Science and Engineering B80, S. 5-9 (2001) gegeben.

Physikalischer Grundmechanismus jeder Wärmebehandlung ist die Diffusion von Eigenfehlstellen und Verunreinigungen unter Beachtung möglicher Einflüsse des Fermi-Niveaus und von Versetzungen, die eine erhöhte Diffusivität besitzen ("pipe diffusion") und mit denen Punktdefekte reagieren können (Segregation). Wegen der Kleinheit der Selbst- und vieler Fremddiffusionskoeffizienten selbst in der Nähe der Schmelztemperatur von GaAs sind die hierdurch bewirkten Ausgleichsvorgänge auf mesoskopische Linearabmessungen (O(100 $\mu$m)) beschränkt. Insbesondere ist eine Homogenisierung der durch Makrosegregation von Dotanden und Verunreinigungen bei der Kristallzüchtung entstandenen axialen und radialen Konzentrationsinhomogenitäten durch ein Kristalltempern nicht möglich.

GaAs speziell besitzt einen Homogenitätsbereich, der die stöchiometrische Zusammensetzung einschließt, mit einer retrograde Löslichkeit zumindest auf der As-reichen Seite des Homogenitätsbereiches (H. Wenzl, W. A. Oates, K. Mika: Defect thermodynamics and phase diagrams in compound crystal growth processes, in: D. T. J. Hurle (ed.): Handbook of Crystal Growth, vol 1A, North-Holland, Amsterdam, 1993). Die Folge der retrograden Löslichkeit ist die Bildung von As-Ausscheidungen beim Überschreiten der Soliduslinie während des Abkühlvorganges, die mit Veränderungen im intrinsischen Defekthaushalt des GaAs gekoppelt ist ("Strukturelle Punktdefekte"). Unterschieden wird zwischen den durch homogene bzw. heterogene Keimbildung gebildeten Matrix- bzw. Dekorationspräzipitaten mit unterschiedlicher Größenverteilung. Die Größenverteilung der Dekorationspräzipitate (DP) ist darüber hinaus von der Versetzungsdichte des Materials abhängig. Mit abnehmender Versetzungsdichte wächst die mittlere Präzipitatgröße an. Das heißt, VGF/VB-GaAs, speziell jenes mit SI-Eigenschaften, weist im Vergleich zum LEC-GaAs größere DP's auf. Auf der anderen Seite weist LEC-GaAs zwar relativ kleine DP's auf, besitzt jedoch relativ hohe Versetzungsdichten von deutlich über 1 x 10⁴ cm⁻². Das Auflösen von Ausscheidungen durch ein Halten im Homogenitätsbereich und das Wiederausscheiden des überschüssigen Arsens durch ein definiertes Abkühlen stellt damit über die Verteilung und die Menge des ausgeschiedenen Arsens eine Möglichkeit zur Kontrolle des Defekthaushaltes, aber auch der As-Ausscheidungen durch Kristalltempern dar. Bei der Wärmebehandlung großformatiger Einkristalle sind allerdings den realisierbaren Aufheiz- und Abkühlraten durch die wärmephysikalischen Eigenschaften des GaAs enge Grenzen gesetzt, wenn die thermischen Spannungen im Interesse einer konstanten Versetzungsdichte bzw. zur Vermeidung von Bruch unterhalb bestimmter Schranken liegen sollen.

Die As-Ausscheidungen verursachen beim mechano-chemischen Polieren der Wafer ätzgrubenartige Defekte in der Oberfläche, die mittels Lichtstreutechniken als sogenannte COP's (Crystal Originated Particles) detektiert und hinsichtlich der Größe klassiert werden und anwendungs- sowie anwenderspezifischen Spezifiaktionen genügen müssen. Die Größenverteilung der COP's hängt u.a. von der jeweiligen Polierprozedur ab, ist aber grundsätzlich der Größenverteilung der As-Ausscheidungen proportional, d. h. die COP's sind im VGF/VB GaAs im Mittel größer als im LEC-Material. COP's können das epitaktische Wachstum stören und eine für die Bauelementefertigung unakzeptable "Rauhigkeit" der Schichtstapel verursachen. Bekannt ist ferner, daß die As-Ausscheidungen das Schaltverhalten durch Ionen-Implantation hergestellter FET's beeinflussen (US5,219,632).

Neben dem in der Praxis üblicherweise durchgeführten Tempern des gesamten Kristalls (Ingot) ist eine Wärmebehandlung einzelner Wafer, das sogenannte Wafertempern, bekannt. Dabei kann im Unterschied zum Kristalltempern ausgenutzt werden, daß bei GaAs (und anderen III-V-Verbindungen) oberhalb der Temperatur der kongruenten Verdampfung das Arsen (die V-Komponente) einen höheren Dampfdruck als Gallium (die III-Komponente) besitzt und auf diese Weise zumindest prinzipiell versucht werden kann, durch einen von außen angelegten As-Partialdruck (z.B. durch Verdampfen von festem Arsen oder auf andere Weise) die Zusammensetzung von GaAs in einem oberflächennahen Bereich der Wafer einzustellen (O. Oda, H. Yamamoto, K. Kainosho, T. Imaizumi, H. Okazaki: Recent developments of bulk III-V materials: annealing and defect control, Inst. Phys. Conf. Ser. No 135, pp 285 - 293, 1993).

Eine weitere bekannte Variante des Wafertemperns ist die Wärmebehandlung nach Ionenimplantation. Sie dient der Aktivierung des implantierten Dotanden, wobei eine selektive As-Verdampfung durch einen der Aktivierungstemperatur entsprechenden As-Partialdruck oder durch eine Diffusionsbarriere aus $Si_3N_4$, AIN oder eine andere Abdeckschicht unterdrückt wird.

So zeigt die EP 0 399 662 A eine Verkapselung eines GaAs-Wafers mit einem Glasfilm, um in einem Rapid Thermal Annealing (RTA) Defekte aus einer vorangehenden Ionenimplantierung auszuheilen. Das Dokument JP 58 143520 A andererseits sieht vor, Arsen (As) in einer Kammer zu verdampfen und das so verdampfte Arsen über Durchgänge in einen Raum zur Bereitstellung eines As-Dampfdrucks zu leiten, wo ein ionenimplantiertes GaAs-Substrat eingebracht wurde.

Beim Wafertempern wurde ausgehend von einer 1-stufigen Wafertemperprozedur (US5,219,632) zur weiteren Verbesserung der mesoskopischen Homogenität eine 2-stufige (JP1927973 B, US5,047,370) und schließlich eine 3-stufige Prozedur (JP04-215439 A, US5,137,847) entwickelt.

Ihnen ist gemeinsam, daß in einem ersten (bei US5,219,632 dem einzigen) Temperschritt bei T > 1100°C und t > 30 min in einer Quarzampulle unter einem nicht näher definierten As-Partialdruck zur Vermeidung einer selektiven As-Verdampfung sowie eine anschließende Abkühlung auf Raumtemperatur mit 1 - 30 K/min die Dichte der sogenannten Mikrodefekte von typischerweise $5x10^5$ $cm^{-2}$ in SI LEC GaAs auf $\leq 5x10^3$ $cm^{-2}$ abgesenkt wird. Unter Mikrodefekten werden Ausscheidungen von Verunreinigungen oder As-Ausscheidungen verstanden, die sich durch die bekannte AB-Ätzung als ovale Ätzpits auf der Waferoberfläche nachweisen lassen. Eingesetzt werden vorzugsweise geläppte und reinigungsgeätzte Wafer ggf. auch im as-grown Zustand. Nach dem beidseitigen Ätzen der getemperten Wafer erfolgt die 2. Temperung bei 750°C - 1100°C (vorzugsweise bei 900°C - 1000°C) für wenigstens 20 min. Wiederum wird in einer Quarzampulle getempert, jetzt jedoch in einer nichtoxidierenden Atmosphäre wie z. B. $N_2$, $H_2$, Ar oder auch $AsH_3$ nicht näher spezfizierten Druckes, d. h. nichtkonservativ ohne As-Potential und damit unter extraktiven Bedingungen oder aber konservativ mit einem As-Partialdruck zur Unterdrückung einer Degradation der Oberflächen. Die Angaben zum Prozeßgas sind somit widersprüchlich. Diese Verfahrensweise ist jedoch insofern denkbar, als die Wafer nach dem Tempern geätzt, vor- und endpoliert werden, so daß eine ggf. veränderte Zusammensetzung im oberflächenahen Bereich ohne Bedeutung ist.

In den Offenlegungen JP08-255799 A, JP08-259396 A und JP09-194300 A wird die 2. Temperung im T-Bereich von 800°C - 1000°C unter einem As-Partialdruck durchgeführt, der wenigstes das 1.4- bis 2.-fache des Druckes über stöchiometrischem GaAs bei der jeweiligen Temperatur beträgt. Damit wird die Stöchiometrieabweichung und hiermit verknüpft die EL2-Konzentration in einem oberflächennahen Bereich erhöht. Aussagen zum Verhalten der As-Ausscheidungen bei dieser Wärmebehandlung werden nicht gemacht.

Bei dem in US5,137,847 bzw. JP04-215439 A beschriebenen 3-stufigen Wafertempern wird eine weitere Temperung bei 520 - 730°C unter As-Partialdruck durchgeführt. In diesem Dokument wird die 3-stufige Temperung hinsichtlich Absenkung der Mikrodefekte und der Homogenisierung als optimal bezeichnet

Nachteilig und unakzeptabel ist die nach dem 1. Temperschritt geforderte hohe Abkühlrate, die bei großformatigen Kristallen, aber auch bei Wafern großen Durchmessers mit hoher Wahrscheinlichkeit zur Versetzungsvervielfachung (Gleitlinienbildung) infolge zu hoher thermischer Spannungen führt. Das befindet sich in Übereinstimmung mit der in der japanischen Offenlegung JP2002-274999 A, die die Aufheiz- und Abkühlrate auf $\leq$ 200 K/h bzw. $\leq$ 100 K/h begrenzt, sowie mit JP2001-135590 A, die ein bestimmtes Temperregime betrifft , bei dem sowohl die Aufheiz- als auch die Abkühlrate T-abhängig verändert werden. Nicht berücksichtigt wird, daß die kritischen Aufheiz- und Abkühlraten zur Vermeidung einer Versetzungsvervielfachung für LEC- und VGF-GaAs unterschiedlich sind. Mit der Anzahl der Temperschritte steigt ferner der Aufwand an Material und Arbeitskraft erheblich an.

In JP09-199508 A wird offenbart, die zu tempernden GaAs-Wafer aufeinanderliegend zu stapeln, über eine elastische Einheit mit einem definierten Druck zusammenzudrücken und so unter nichtoxidierender Atmosphäre ($N_2$, Ar, $H_2$, $AsH_2$) in einem Behälter im T-Bereich zwischen 800 - 1000°C zu tempern.

In der JP05-082527 A wird eine Vorrichtung zum Tempern von Wafern in vertikaler Anordnung offenbart. Sie besteht aus 3 azimutal versetzten Haltestäben mit Einschnitten zur Waferaufnahme in einem bestimmten Abstand. Die Haltestäbe sind in einem Kegelflansch befestigt. Sie sind hohl ausgeführt, können (ein) Thermoelement(e) aufnehmen und mit Kühlgas beaufschlagt werden. Diese Vorrichtung wird in eine vertikal angeordnete Quarzampulle mit einem entsprechenden Kegelschliff eingesetzt. Die Ampulle besitzt am unteren Ende eine Verlängerung zur Aufnahme von metallischem Arsen. Sie ragt in einen separaten Heizer, über dessen Temperatur der As-Partialdruck in der Ampulle kontrolliert und so eine Degradation der Wafer verhindert werden kann. Die Wafer werden durch einen Ofen mit mehreren separaten Heizern erwärmt, die mit Hilfe des Innenthermoelementes so gesteuert werden, daß über die Einbaulänge der Wafer eine konstante Temperatur aufrechterhalten werden kann. Die Ampulle kann evakuiert werden. Die Ampulle mit im Inneren angeordneten Wafern kann über einen Kegelschliff verschließbar oder auch abgeschmolzen sein. Statt nur einen Wafer pro Etage können nach JP2000-294561 auch zwei sich mit den Rückseiten berührende GaAs Wafer eingebaut werden.

Gemäß der JP06-302532 A und ähnlich hierzu in JP10-287500 A und JP10-289883 A werden die Wafer auf Unterlagen aus wärmebeständigen Werkstoffen wie pBN, Graphit, Silizium, Wolfram, Molybdän aufgelegt und diese Unterlagen vertikal oder horizontal gestapelt und so in die Temperampulle eingebaut. Bohrungen zwischen den Waferauflagen dienen bei horizontaler Lagerung der Wafer auf Unterlagen der besseren Wechselwirkung mit dem Prozeßgas (s. JP10-321540 A).

In der EP 0 399 662 A wird ein Verfahren zum Ausheilen von Halbleitern des Typs $A_3B_5$ (oder III-V) und $A_2B_6$ (II-VI) beschrieben, bei dem der Halbleiter, nachdem dessen Oberfläche durch einen Glasverkapselungsfilm verkapselt wurde, einer schnellen thermischen Ausheilung (RTA) unterzogen wird, um durch Ionenimplantation verursachte Beschädigungen der oberflächennahen Zone auszuheilen. In einer Behandlungsvorrichtung ist über einem Wafer 1 einer Dicke von ca. 500 $\mu$m mittels Abstandsring 11, der typischerweise eine Höhe von 600 bis 900 $\mu$m aufweist, ein Deckel 12 vorgesehen, so daß ein Freiraum von mindestens 100 $\mu$m gebildet ist, der dem Wafer eine Erweiterung (Ausdehnung) gestattet und eine gleichmäßige Wärmeübertragung zum Wafer ermöglicht. Der Verkapselungsfilm sorgt bewußt für eine Sperre über der Wafer-Oberfläche, so daß zwischen dem Halbleitermaterial des Wafers und dem Freiraum ein Kontakt bzw. Stoffaustauch (Verdampfung der III- bzw. V-Komponente) unterbunden wird.

Es ist Aufgabe der vorliegenden Erfindung, eine Vorrichtung und ein Verfahren zur kostengünstigen Produktion von III-V-Wafern, vorzugsweise von GaAs-Einkristallen und insbesondere von mittels des VGF/VB-Verfahrens hergestellten Wafern bereitzustellen sowie Wafer als solche bereitzustellen, die eine gute Homogenität von elektrischen und physikalischen Eigenschaften sowie eine verbesserte Oberflächenqualität besitzen.

Die Aufgabe wird erfindungsgemäß gelöst durch eine Vorrichtung nach Anspruch 1, durch ein Verfahren nach Anspruch 8, sowie durch einen GaAs-Halbleitereinkristallwafer nach Anspruch 18 oder 19. Bevorzugte Ausführungsformen sind in den Unteransprüchen festgelegt.

Die vorliegende Erfindung und ihre Vorteile und bevorzugten Ausführungsformen, ohne die Erfindung jedoch darauf zu beschränken, werden nachfolgend näher beschrieben.

Die Vorrichtung zum Wärmebehandeln (Tempern) von Wafern, die ein III-V-Halbleitermaterial umfassen, weist mindestens eine Wafer-Trägereinheit auf, die in ihrer Dimension so bemessen ist, daß, nach Auflage des zu tempernden Wafers auf dem Träger, über der Waferoberfläche, die das III-V-Halbleitermaterial umfaßt, eine Decke ohne Abstand oder in einem Abstand von maximal 2 mm zur Waferoberfläche ausgebildet ist.

Die Wirkung ist besonders gut, wenn die Decke durch eine sich über die gesamte Oberfläche des zu tempernden Wafers erstreckende Abdeckung gebildet wird.

Die Wafer-Trägereinheit kann eine mechanisch-druckfreie Auflage eines einzelnen Wafers pro Trägereinheit, z.B. nur mit seinem Eigengewicht, ermöglichen.

Der Wafer-Auflageboden und/oder die Decke, vorzugsweise beides, ist vorzugsweise vollständig oder teilweise und insbesondere in einem dem Wafer zugewandten Oberflächenbereich, gaspermeabel, z.B. durch eine poröse und insbesondere eine mikroporöse Struktur. Das vorzugsweise gaspermeable Material des Auflagebodens und/oder der Decke weist ferner bevorzugt eine hohe Wärmeleitfähigkeit und eine hohe Ebenheit auf. Geeignete gaspermeable Materialien sind zum Beispiel Graphit, Keramiken wie beispielsweise $Al_2O_3$, und Cermets mit jeweils passender Porosität. Die Porosität kann je nach dem eingesetzten Material und dem gewünschten Anwendungsfall (Wafermaterial, Tempertemperatur, Abstand des Auflagebodens zur Decke, etc.) durch dem Fachmann bekannte Methoden eingestellt werden, wobei vorzugsweise der Wafer-Auflageboden und/oder die Decke mindestens in der zur Waferoberfläche zugewandten Oberfläche offenporig sein sollte. Die offene Porosität des porösen Materials für Wafer-Auflageboden und/oder Decke kann geeigneterweise 20 Vol.% oder weniger, bevorzugt 15 Vol% oder weniger und weiter bevorzugt 10 Vol% oder weniger betragen. Es ist auch möglich, nur einen Teil von Wafer-Auflageboden und/oder Decke, die den eingelegten Wafer umgeben, porös bzw. gasdurchlässig auszugestalten, während der übrige Teil gasdicht und/oder mit einem gasdichten, gut Wärme leitenden Material wie Saphir ($Al_2O_3$), $SiO_2$ gebundenem $ZrO_2$ oder SiC zu beschichten. Eine gute Wirkung wurde auch erzielt mit einer SiC-beschichteten Graphitkassette, die Wafer-Auflageboden und Decke bildet, die mit Ausnahme des Bereiches der weiter unten beschriebenen Diffusionssperre, d.h. dem Randbereich, in dem sich die gestapelten Kassetten berühren, gasdicht ist. Wegen der dadurch erzielbaren besonders hohen Wärmeleitfähigkeit und hohen Ebenheit ist ein Material für Wafer-Auflageboden und/oder Decke besonders bevorzugt, welches durch Verdichten von Graphit, das weiter bevorzugt aus hochreinen Graphitpartikeln zusammengesetzt ist, gefertigt wurde. Geeignet sind aber auch andere, vorzugsweise hochreine, auf Restporosität hoch verdichtbare Materialien oder Mischungen verschiedener Materialien. Die Decke ist bevorzugt aus dem gleichen gaspermeablen, porösen Material wie der Auflageboden gefertigt. Dies kann zum Beispiel in der unten näher beschriebenen Ausführung mit Kassettenform realisiert werden.

Durch das Vorsehen des begrenzten Abstands und/oder gegebenenfalls durch die Porenstruktur wird ein Mikrovolumen definiert. Die zu behandelnde, das III-V-Halbleitermaterial umfassende Oberfläche ist nicht durch ein anderes Material verschlossen oder verkapselt; vielmehr hat die genannte Oberfläche infolge des begrenzten Abstands zur Abdeckung und/oder der Porosität eines anderen Materials Kontakt mit dem so definierten Mikrovolumen. Folglich kann ein Stoffaustausch zwischen III-V-Halbleitermaterial und Mikrovolumen stattfinden. Insbesondere können vorteilhaft Transport und/oder Austausch der V-Komponente wie z.B. As oder P zwischen dem III-V-Halbleitermaterial und dem definierten Mikrovolumen stattfinden. Dadurch können auf besonders wirksame Weise einerseits eine Degradation der Oberflächen unter Bildung von Ga-Tröpfchen sicher ausgeschlossen und andererseits Wafer mit erhöhten Gebrauchseigenschaften hergestellt werden. Es werden eine verbesserte Oberflächenqualität durch ein Absenken der COP's erreicht und die charakteristische Bruchfestigkeit der getemperten Wafer signifikant verbessert. Es wird angenommen, daß durch das definierte Mikrovolumen eine besonders gute Homogenisierung des Oberflächenbereichs des getemperten Wafers bewirkt wird. Die Wirkung ist besonders gut, wenn die Wafer-Trägereinheit in ihrer Dimension so bemessen ist, daß der Abstand zwischen der Oberfläche des aufzulegenden Wafers und der darüber liegenden Decke bzw. Abdeckung 0,05 - 0,75 mm, weiter bevorzugt 0,2 - 0,5 mm und insbesondere 0,3 - 0,4 mm beträgt und ein dementsprechendes Mikrovolumen bildet. Nimmt man z.B. auf eine typische Waferdicke von 0,5 - 1 mm Bezug, ohne die Erfindung jedoch darauf zu beschränken, würde folglich der Abstand vom Auflageboden bis zur Decke der Wafer-Trägereinheit mindestens etwa 0,5 mm (d.h. bei Verwendung eines 0,5 mm-Wafers und lückenloser Auflage des Deckels auf dem Wafer) bis maximal etwa 3 mm (d.h. bei Verwendung eines 1 mm-Wafers und Anwendung des Maximalabstands des Wafers zum Deckels von 2mm) betragen. Die Wafer-Trägereinheit ist in ihrer Dimension vorzugsweise ferner so bemessen, daß ein Volumendurchmesser definiert ist, der größer und insbesondere geringfügig größer als der Durchmesser des zu behandelnden Wafers ist und beispielsweise maximal 110%, vorzugsweise 105%, weiter bevorzugt maximal 101 % des Durchmessers des zu behandelnden Wafers entspricht.

Die Wafer-Trägereinheit kann in einer besonderen Ausführungsform einen den Wafer aufnehmenden, begrenzten Raum derart bilden, daß ein ungehinderter freier Gaszutritt zu den Waferoberflächen verringert und vorzugsweise verhindert ist. Andererseits ist ein hermetisches Versiegeln des Wafers in der Trägereinheit nicht erwünscht. Demnach liegt vorzugsweise eine Gasaustauschrate zwischen der Atmosphäre im Mikrovolumen und der Atmosphäre außerhalb der Wafer-Trägereinheit vor, ist jedoch im Vergleich zu einem freien Gasaustausch wesentlich verringert. Die technische Realisierung wird unten durch Bezugnahme auf geeignete Diffusionshindernisse näher beschrieben.

Die Wafer-Trägereinheit ist vorzugsweise zur durchgehenden, horizontal flächigen Auflage der gesamten unteren Oberfläche des Wafers ausgestaltet. Um die Auflage möglichst gleichmäßig zu machen, sind im Auflageboden keine Bohrungen vorgesehen. Erfindungsgemäß können Spannungen vermieden werden, die bei nicht horizontalen und bei nicht durchgehenden Auflagen und insbesondere bei punktuellen Auflagen durch den Einfluß des Wafer-Eigengewichts beim Tempern auftreten können, weil durch den Auflagedruck im Glühgut die (T-abhängige) Fließspannung überschritten wird, was zur Bildung von Versetzungen und unakzeptablen Gleitlinien führt. Dieser Einfluß ist bei GaAs wegen der vergleichsweise großen Dichte besonders ausgeprägt.

Ein weiterer Vorteil sind (radial) homogenere Temperaturverteilungen während des Aufheizens und Abkühlens, und auch während des Haltens, was wiederum thermische Spannungen in den Wafern und ggf. eine globale Geometrieänderung der Wafer (Verschlechterung z. B. des "warp" im Vergleich zum Zustand vor dem Tempern), aber auch eine örtlich unterschiedliche Wechselwirkung zwischen Wafer und Prozeßgas vermeidet. Aufheiz- und Abkühlraten können daher besser und T-variabel gesteuert werden.

Gemäß der Erfindung kann die Wechselwirkung zwischen dem Prozeßgas und der Waferoberfläche gleichmäßig gemacht werden und ist unabhängiger von der globalen geometrischen Qualität sowie vom physikalisch-chemischen Oberflächenzustand der Wafer.

Durch die bevorzugte Auflage nur eines einzigen Wafers pro Wafer-Trägereinheit kann ein Versintern von Wafern untereinander vermieden werden.

Besonders bevorzugt weist die Vorrichtung eine Mehrzahl von Wafer-Trägereinheiten auf, die in Kassettenform so stapelbar sind, daß eine Wafer-Trägereinheit einen Auflageboden für einen ersten (n-ten) Wafer aufweist und eine entsprechende, darauf gestapelte Wafer-Trägereinheit für einen darüberliegenden zweiten ((n+1)-ten) Wafer die höhenbegrenzende Decke bzw. Abdeckung für den Raum des ersten (n-ten) Wafers bildet.

Die Wafer-Trägereinheit, in ihrer vereinzelten Form und in der mehrfach gestapelten Kassettenform, weist eine passende Außenumrandung auf, die um den kreisförmigen Rand des zu behandelnden Wafers gebildet ist und den Raum bzw. das Mikrovolumen nach außen abschließt. Die Außenumrandung weist bevorzugt ein Gas-Diffusionshindernis auf, um einen begrenzten Gasaustausch von außen mit dem Mikrovolumen zu ermöglichen. Dies erfolgt zweckmäßigerweise durch passende Formstruktur und/oder Materialauswahl im Auflagebereich benachbarter Wafer-Trägereinheiten, insbesondere an der Auflagefläche dazwischen. Geeignet sind beispielsweise gegenüber einem Gasaustausch nicht hermetisch abschließende Deckel/Unterlagestrukturen, etwa wenn zwischen benachbarten Wafer-Trägereinheiten ein Bodeninnenkreis der oben liegenden Wafer-Trägereinheit in den Umkreis der darunter liegenden Wafer-Trägereinheit eingreift und/oder eine Oberflächenrauhigkeit oder eine andere diffusionshemmende geometrische Struktur vorgesehen ist. Ein alternatives oder zusätzliches Diffusionshindernis ist dadurch möglich, daß an den Berührungsflächen am Umkreisrand von benachbarten Wafer-Trägereinheiten ein Diffusionsbarrierematerial wie $Si_3N_4$, AlN oder dergleichen gebildet ist. Besonders einfache und wirksame Diffusionshindernisse sind ein oder mehrere, an der Peripherie der Wafer-Trägereinheit umlaufende dreieckförmige Rippen, die in Nuten gleichen Querschnitts der benachbarten Wafer-Trägereinheit eingreifen. Eine oben beschriebene offene Porenstruktur im Auflageboden und/oder im Deckel, bei der Stapelausführung einschließlich des Auflageboden der untersten Wafer-Trägereinheit und des Deckel der obersten Wafer-Trägereinheit, können ebenfalls als Gas-Diffusionshindernis zum stark begrenzten Gasaustausch nach außen beitragen.

Für das Temperverfahren wird der Wafer so eingelegt, daß die Frontseite des Wafers, die später die Funktionsseite des Wafers bildet, zum Mikrovolumen hin zeigt.

Für das Erreichen von großen Wafern mit verbesserten Eigenschaften ist es vorteilhaft, wenn der das III-V-Halbleitermaterial umfassende Wafer zunächst aus as-grown III-V-Einkristallen nach dem Rundschleifen mit einem Durchmesser von > 100 mm, gegebenenfalls von > 150 mm oder von > 200 mm herausgetrennt wird, z.B. mittels Drahtläppens oder Innenlochsägens, anschließend einem Schritt zum Reinigen und Ätzen unterzogen wird und dann, noch bevor ein Schritt zum Kantenverrunden durchgeführt wird, in einer Wärmebehandlungsvorrichtung, die vollständig ohne Kieselglas-Bauteile wie eine Quarzampulle auskommt, wärmebehandelt wird. Die oben beschriebene Wafer-Trägereinheit ist zur Anwendung in einem solchen Behandlungsverfahren besonders gut geeignet, da sie in einer Wärmebehandlungsvorrichtung ohne Kieselglas-Bauteile eingesetzt werden kann. Das Tempern in quarzfreier Umgebung dient zur Absenkung des Kontaminationsrisikos, z.B. durch Cu, weshalb zum Beispiel die Konzentration an anderen Verunreinigungen als Kohlenstoff und Bor bevorzugt auf insgesamt höchstens $5\times10^{14}$ cm$^{-3}$ und vorzugsweise auf höchstens $2\times10^{14}$ cm$^{-3}$ begrenzt werden kann. Ferner wird das Verfahren dadurch einfacher und kostengünstiger. Außerdem kann mit der genannten Reihenfolge der Verfahrensschritte besonders gut eine gleichmäßige Extraktion im Oberflächenbereich und ein Homogenisierung des Wafers erhalten werden. Die Weiterverarbeitung der Wafer nach dem Tempern erfolgt in Analogie zur Verfahrensweise mit kristallgetemperten Wafern. Das Kantenverrunden erfolgt vorteilhaft nach dem Tempern der einzelnen Wafer, wodurch etwa noch auftretende Inhomogenitäten oder Defekte am umlaufenden Waferrand beseitigt werden können.

Durch das erfindungsgemäße Konzept kann eine Vorrichtung und ein Verfahren zur Wärmebehandlung eines Wafers, das ein III-V-Halbleitermaterial umfasst, bei erhöhter Temperatur bereitgestellt werden, wobei der Wafer, der mittels Trennen aus as-grown III-V-Einkristallen mit einem Durchmesser von ≥ 100 mm hergestellt wurde, in einem Zustand wärmebehandelt wird, bei dem eine zu behandelnde Oberfläche des III-V-Halbleitermaterials

- entweder direkt durch ein gaspermeables und/oder poröses Material bedeckt wird, oder
- durch ein Material, das gaspermeabel und/oder porös ist oder nicht, bei einem Abstand von über 0 mm bis maximal etwa 2 mm überdeckt wird.

Durch diese alternativen Maßnahmen wird ein Mikrovolumen über der zu behandelnden III-V-Oberfläche geschaffen, das zum Transport und/oder zum Austausch der V-Komponente wie z.B. As oder P in den Mikrogasraum bzw. aus diesem Gasraum befähigt.

Das Abdeckmaterial, sowohl die gaspermeable und/oder poröse Form als auch die Masseform, ist fest und wärmebeständig. Bevorzugte Materialien sind wie oben erwähnt Graphit, Keramiken wie beispielsweise $Al_2O_3$, und Cermets. Wird die gaspermeable und/oder poröse Form gewählt, wird eine geeignete Porosität eingestellt, die z.B. durch Verdichten von entsprechenden genannten Ausgangsmaterialien in Teilchenform, wie etwa Graphitteilchen, erhalten wurde. Vorzugsweise wird auch der Rand sowie die Unterseite des zu behandelnden Wafers direkt oder mit dem genannten Abstand von dem genannten Material umgeben.

Das erfindungsgemäße Verfahren in den oben beschriebenen Ausführungsformen ermöglicht ein einstufiges Tempern anstelle von mehrstufigen Temperregimen. Dadurch werden die Kosten der Wärmebehandlung reduziert. Das Tempern der Wafer erfolgt vorzugsweise im Temperaturbereich von 750 - 1150°C, weiter bevorzugt von 800 - 1050 °C. Die Atmosphäre wird vorzugsweise durch ein Inertgas, z.B. aus Stickstoff oder Argon, und insbesondere mit einem Wasserstoffgehalt von mind. 0,5 Vol. % und einem Gesamtdruck von 10 - 20 bar gebildet.

Im Fall der Herstellung von z.B. GaAs-Wafern ist es vorteilhaft möglich, die Temperung von as-grown-Wafern ohne vorgegebenen As-Partialdruck durchzuführen. Es wird angenommen, daß die Verwendung der erfindungsgemäßen Vorrichtung aus sich heraus eine günstige As-Atmosphäre im oben beschriebenen Mikrovolumen erzeugt, um eine kontrollierte As-Extraktion aus dem, und/oder eine Einstellung der As-Verteilung in dem dem Mikrovolumen zugewandten Oberfächenabschnitt des Wafers zu bewirken. Im Fall der Herstellung von z.B. InP-Wafern kann es andererseits vorteilhaft sein, die Temperung von as-grown Wafern mit vorgegebenen P-Partialdruck durchzuführen, um ein Eindiffundieren in den, und/oder eine Einstellung der P-Verteilung in dem dem Mikrovolumen zugewandten Oberfächenabschnitt des Wafers zu bewirken.

Zur Durchführung der Wärmebehandlung befindet sich die erfindungsgemäße Temperbehandlungsvorrichtung in einem T-konstanten Raum. Als zu verwendendem Ofen wird eine Mehrheizeranordnung bevorzugt; beispielsweise enthält der Ofen einen Mantelheizer und zwei Deckelheizer. Die Einstellung eines As-Partialdrucks im Temperofen ist nicht erforderlich und kann zugunsten einer Einfachheit und Effektivität der Temperung weggelassen werden.

Die Haltezeit bei der Tempertemperatur kann so lange ausgedehnt werden, bis eine gewünschte und je nach Anwendungsfall vorteilhafte Tiefe einer Extraktion (z.B. von As) der V-Komponente und/oder einer Einstellung der Verteilung der V-Komponente, was z.B. anhand der Verteilung der As-Ausscheidungen durch die Laser Scattering Tomographie (LST) feststellbar ist, erreicht ist.

Eine bevorzugte Tiefe einer As-Extraktion und/oder Konzentrationseinstellung der V-Komponente beträgt mindestens $40\mu m$. Sie ist jedoch nicht darauf beschränkt und kann sich sogar durch den gesamten Dickenbereich des Wafers erstrecken.

Eine Beziehung zwischen der gewünschten Haltezeit bei der Tempertemperatur und einer mittleren As-Extraktionstiefe $L_{eff}$ ist durch folgende Formel gegeben:

$$L_{eff} = \left( 2 \int_0^{t_o} D(T[t']) dt' \right)^{1/2} .$$

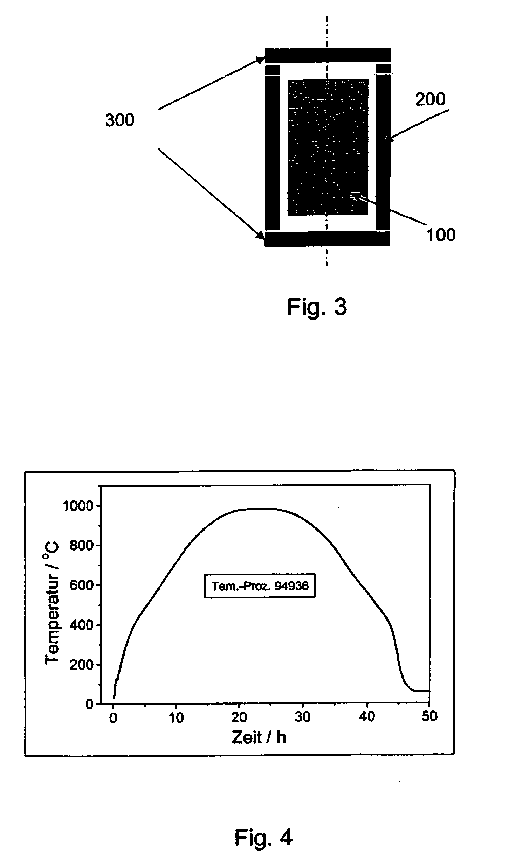

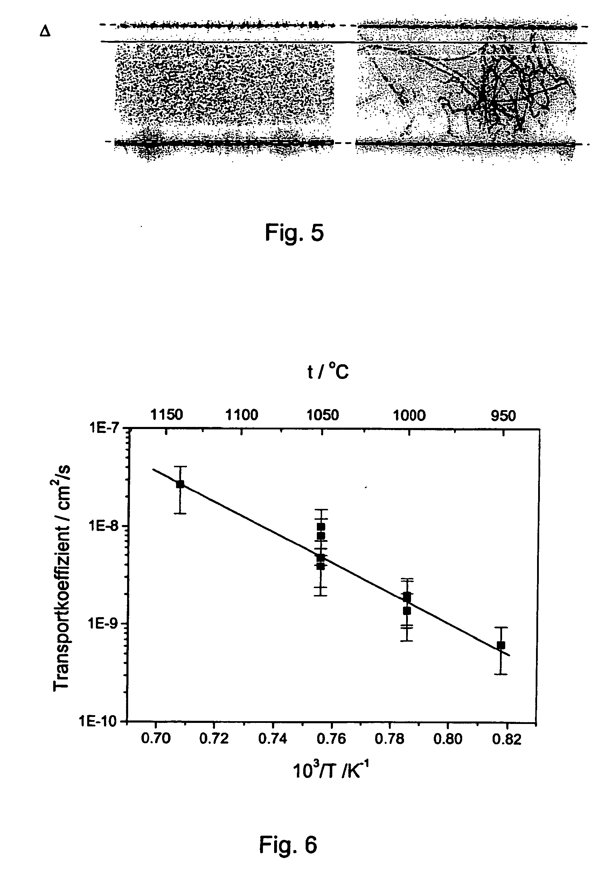

Hierin ist D(T) der Transportkoeffizient von As (s. auch Fig. 6 unten) und T(t) das Temperatur-Zeit-Profil der Temperung (s. z.B. Fig. 4 unten), deren Gesamtdauer $t_o$ beträgt. Näherungsweise gilt: $L_{eff} = \sqrt{2D(T)t}$ , worin D (T) der Transportkoeffizient bei der Tempertemperatur T und t die Haltezeit bei dieser Temperatur sind. Unberücksichtigt bleibt hierbei die Aufheiz- und Abkühlperiode des Temperregimes.

Weitere besondere Vorteile des Verfahrens ergeben sich daraus, daß sich die Auf- und die Abkühlraten jeweils T-abhängig variabel sehr gut einstellen lassen. So ist es sehr effizient möglich, daß die Auf- und die Abkühlraten im T-Bereich über 400°C bis zur Solltemperatur von 30 - 40 K/min auf 0 abgesenkt bzw. von $\approx$ 0 auf 30 - 40 K/min erhöht werden. Ein weiterer Vorteil besteht darin, daß, falls gewünscht, die EL2°-Konzentration von as-grown VB/VGF-Wafern mit einer Versetzungsdichte < 1x10$^4$ cm$^{-2}$ um mindestens 30 % erhöht werden kann. Ferner können die EL2°-Konzentration und der mesoskopische Widerstand vorteilhaft stark homogenisiert werden, insbesondere auf einen Bereich von jeweils $|\Delta[EL2°]/[EL2°]| \leq 7,5$ % und $\sigma_{mesos} \leq 6$ % und sogar auf einen Bereich von jeweils $|\Delta[EL2°]/[EL2°]| \leq 5$ % und $\sigma_{mesos} \leq 5$ %. Auch die Oberflächenqualität wird signifikant verbessert, was sich insbesondere in einer stark verminderten lpd (light point defects) wie z.B. von lpd(0.3 - 2.0 $\mu m$) < 0,3 cm$^{-2}$ ausdrückt.

Durch die genannten vorteilhaften Ausgestaltungen des erfindungsgemäßen Verfahrens ist eine problemlose Integration der Wärmebehandlung in den technologischen Ablauf der Waferfertigung möglich.

Die mit der erfindungsgemäßen Vorrichtung und dem erfindungsgemäßen Verfahren erhältlichen III-V-Halbleitereinkristallwafer, insbesondere die einkristallinen SI GaAs-Wafer, besitzen eine für die Bauelementefertigung vorteilhafte erhöhte Bruchfestigkeit. Ferner besitzen diese Wafer eine verbesserte radiale makroskopische und mesoskopische Homogenität und eine verbesserte Qualität der mechano-chemisch polierten Oberflächen. Es wird vermutet, daß ein Grund für die verbesserten Eigenschaften eine durch die erfindungsgemäße Vorrichtung bzw. das erfindungsgemäße Verfahren erzielbare Konzentrationseinstellung von chemischen Bestandteilen, speziell der V-Komponente der III-V-Halbleiterverbindung wie dem As (im Fall von GaAs) oder P (im Fall von InP), und/oder eine Homogenisierung von physikalischen Parametern, wie der EL2-Konzentrationsverteilung, ist. Indem ein Mikrovolumen definiert und gegebenenfalls weitere Prozeßparameter wie Bestandteile und Drücke der Gasatmosphäre eingestellt werden, kann mit den erfindungsgemäßen Wafer-Tempereinheiten und Temperkassetten eine kontrollierte Extraktion der V-Komponente wie im Fall von As bei GaAs erreicht werden. Vorrichtung und Verfahren sind vorzugsweise anwendbar auf die Wärmebehandlung von SI GaAs-Wafern, die aus Einkristallen hergestellt wurden, die nach dem Vertikalen Bridgman Verfahren (VB) und seinen Varianten (z. B. dem Vertical Gradient Freeze Verfahren - VGF), d. h. Verfahren mit im Vergleich zum Liquid Encapsulated Czochralski-Verfahren (LEC) signifikant kleineren Nichtlinearitäten des 3D-Temperaturfeldes, gezüchtet wurden. Mittels dieser Verfahren gezüchtete III-V-Kristalle und daraus gefertigte Wafer und insbesondere SI GaAs-Wafer größerer Durchmesser wie $\geq$ 100mm und $\geq$ 150 mm weisen Versetzungsdichten unter 1 x 10$^4$ cm$^{-2}$ auf, und die charakteristische Bruchfestigkeit, definiert als die Bruchfestigkeit, bis zu der 63,2 % (Weibull-Verteilung) der Wafer ausgefallen sind, ist gegenüber derjenigen für SI GaAs Wafer aus kristallgetempertem Material um mindestens 25 % erhöht. Die charakteristische Bruchfestigkeit beträgt mehr als 1900 MPa und bevorzugt mehr als 2000 MPa, jeweils mit einem Vertrauensbereich von < +/- 200 MPa. Die charakteristische Bruchfestigkeit ist durch Standardmethoden bestimmbar, wie zum Beispiel in DIN 51110/Teil 3 bzw. EN843-5 (Entwurf) bzw. W. Timischl: Qualitätssicherung, Carl Hanser Verlag München Wien, 1996, ISBN 3-446-18591-1 beschrieben. Es ist ausreichend, eine 2-parametrige Weibull-Verteilung für die Ermittlung des charakteristischen Wertes zu verwenden.

Insbesondere ist mit dem erfindungsgemäßen Verfahren ein III-V-Halbleitereinkristallwafer mit einer einzigartigen Kombination von Merkmalen erhältlich, die durch einen oder mehrere, bevorzugt alle der folgenden Parameter definiert ist:

- Waferdurchmesser $\geq$ 100 mm, vorzugsweise $\geq$ 150 mm;
- Versetzungsdichte < 1 x $10^4$ cm$^{-2}$;
- einer Konzentration an anderen Verunreinigungen als Kohlenstoff und Bor von insgesamt $\leq$ 5x$10^{14}$ cm$^{-3}$, vorzugsweise von $\leq$ 2x$10^{14}$ cm$^{-3}$,
- einer Homogenität der EL2°-Konzentration von $|\Delta[EL2°]/[EL2°]| \leq 7,5$ % und einer mesoskopischen Homogenität von $\sigma_{mesos} \leq 6$ %, vorzugsweise mit $|\Delta[EL2°]/[EL2°]| \leq 5$ % und $\sigma_{mesos} \leq 5$ %,
- Ipd(0.3 - 2.0 $\mu$m) < 0,3 cm$^{-2}$.

Die vorliegende Erfindung und die bevorzugten, jedoch nur beispielhaften und nicht einschränkend zu verstehenden Ausführungsformen werden nachfolgend anhand der beigefügten Zeichnungen weiter erläutert, wobei:

Fig. 1 zeigt schematisch im Querschnitt eine Ausführungsform von gestapelten Temperkassetten mit einer Mehrzahl einzelner Wafer-Trägereinheiten gemäß der Erfindung;
Fig. 2 zeigt schematisch die Ausführungsform nach Fig. 1 im Detail, mit einer Ausführungsart für ein zusätzliches Diffusionshindernis;
Fig. 3 zeigt schematisch im Querschnitt einen Temperofen, in den eine Stapelung mehrerer Wafer-Trägereinheiten eingebaut ist;
Fig. 4 zeigt ein Beispiel für einen erfindungsgemäßen Temperatur-Zeit-Verlauf der einstufigen Wafertemperung;
Fig. 5 zeigt ein LST-Mapping eines getemperten Wafers in Kantenansicht mit Matrixpräzipitaten (Darstellung links) und Dekorationspräzipitaten (Darstellung rechts); und
Fig. 6 zeigt die Temperaturabhängigkeit des effektiven Transportkoeffizienten für das extraktive Wafertempern.

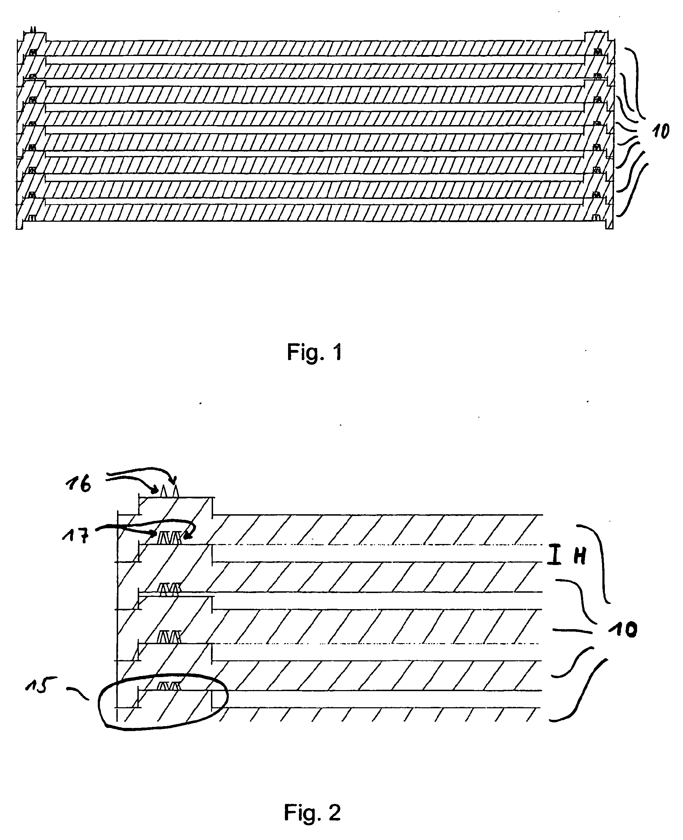

In Fig. 1 und detaillierter in Fig. 2 sind in einer Ausführungsform der Erfindung gestapelte Temperkassetten mit einer Mehrzahl einzelner Wafer-Trägereinheiten 10 schematisch gezeigt. Jede der Wafer-Trägereinheiten 10 kann jeweils einen Wafer (nicht gezeigt) aufnehmen. Die Wafer liegen auf dem mit höchstmöglicher Ebenheit gefertigten Boden der Kassetten aus z. B. hochdichtem, aber gaspermeablem Graphit hoher Temperaturleitfähigkeit mit der Rückseite auf. Die einzelnen baugleichen Kassetten sind so gefertigt, daß sie über die Umkreisränder lückenlos gestapelt werden können, wobei der Boden der darüberliegenden Kassette den Deckenabschluß der darunterliegenden bildet und zwischen ihnen ein (bezüglich einer Waferdicke d angepaßter) Raum (mit der dargestellten Gesamthöhe H) für die Aufnahme des Wafers bleibt. Vorzugsweise bleibt noch ein zusätzliches Freivolumen. Ein Mikrovolumen wird gebildet durch die offene Porenstruktur des Waferträgers selbst und, falls bevorzugt der Abstand (H-d) zwischen Decke und Waferoberfläche vorgesehen ist, durch das gemäß dem gewählten Abstand zusätzlich gebildeten Freivolumen. Im letztgenannten Fall ist das Freivolumen durch den Abstand zur Waferoberfläche (nicht gezeigt) von maximal 2 mm, vorzugsweise 0,05 - 0,75 mm, weiter bevorzugt 0,2 - 0,5 mm und insbesondere 0,3 - 0,4 mm Höhe, sowie durch den Träger-Durchmesser $2R_T$ von größer als dem Durchmesser des zu behandelnden Wafers bestimmt, z.B. maximal 110 %, bevorzugt maximal 105 % und weiter bevorzugt maximal 101 % des Durchmesser des zu behandelnden Wafers. Das Freivolumen wird durch eine Deckel/Boden-Eingriffsstruktur 15 am umlaufenden Rand nach außen abgeschlossen. Auf dem Auflagerand der Waferträger befindet sich ein zusätzliches Gas-Diffusionshindernis, das vorzugsweise durch umlaufende Rippen 16 auf der untenliegenden Wafer-Trägereinheit gebildet wird, die in entsprechende Nuten oder Aussparungen 17 der darüberliegenden, abdeckenden Wafer-Trägereinheit eingreifen (s. Fig. 2). Als Abschluß der Temperkassetten nach oben kann eine unbesetzte bzw. mit einem Dummy-Wafer besetzte Wafer-Trägereinheit oder ein spezieller Deckel (nicht gezeigt) vorgesehen werden.

Auf diese Weise kann ein nachteiliger direkter Kontakt einzelner Wafer, wie es z.B. in JP09-199508 A vorgesehen ist, vermieden werden. Die Anzahl der einsetzbaren Kassetten (Wafer-Trägereinheiten) hängt von der Länge der T-konstanten Zone des verwendeten Temperofens ab und betrug bei der gezeigten Ausführungsform beispielsweise 90. Das z.B. aus zwei umlaufenden, dreieckförmigen Rippen und Nuten bestehende Diffusionshindernis (s. Fig. 2) reduziert den As-Verlust aus dem Mikrovolumen beim Tempern hauptsächlich auf den diffusiven Transport durch das mikroporöse Graphit. Die Kassetten mit Mikrovolumen sind damit prinzipiell verschieden von den im Stand der Technik z.B. gemäß JP05-082527 A und JP06-302532 A beschriebenen Waferträger-Einrichtungen, die einen freien Gaszutritt zu den Waferoberflächen ermöglichen. Mit der Auflage der gesamten Waferfläche auf der erfindungsgemäßen Wafer-Trägereinheit werden zudem die oben beschriebenen Probleme bei punkt- oder bereichsweiser Auflage (vgl. insbesondere JP05-082527 A) sicher vermieden. Ferner werden hierdurch das Aufwärmen und Abkühlen auf Tempertemperatur beschleunigt und T-Inhomogenitäten über den Wafer in der Haltephase verringert.

Die Dicke der eingesetzten Wafer ist der Sägedicke bei konventioneller Fertigung gleich, d. h. das erfindungsgemäße Wafertempern erfordert keine Veränderung der Maßketten der Waferfertigung.

Wie in Fig. 3 schematisch gezeigt wird nach dem Befüllen der Kassetten mit Wafern , zum Zweck der Homogenisierung des T-Feldes, über den Kassettenstapel ein zum Außendurchmesser der Kassetten passendes Graphitrohr geschoben und an beiden Enden mit Graphitplatten abgeschlossen. Der so gebildete Temperblock (in Fig. 3 mit dem Bezugszeichen 100 bezeichnet) wird in die T-konstante Zone eines vertikalen Kaltwand-Temperofen eingebaut. Der Ofen besitzt eine Mehrheizeranordnung oder enthält, wie in Fig. 3 gezeigt, einen Mantelheizer 200 und zwei Deckelheizer 300 und ist in einen wassergekühlten, evakuierbaren Druckbehälter (in Fig. 3 nicht gezeigt) eingebaut. Ein As-Partialdruck im Temperofen, der herkömmlich üblicherweise in einer Quarzampulle realisiert wird, ist folglich weder möglich noch nötig. Der beschriebene Aufbau enthält keine Bauteile aus Quarz, wodurch eine aus dem Quarz stammende Kontamination der Wafer ausgeschlossen ist.

Die Wärmebehandlung der Wafer erfolgt unter Reinststickstoff oder Reinstargon, jeweils aus Flüssiggasen entwickelt, mit einem Zusatz von ≤ 1 Vol.% Wasserstoff. Bevor das Prozeßgas aufgedrückt wird, wird der Druckbehälter 3 x abwechselnd bis auf $10^{-3}$ mbar evakuiert und mit Reinststickstoff gespült. Auf das verfahrenstechnisch aufwendige Tempern unter einem As-Partialdruck kann somit verzichtet werden. Getempert wird im T-Bereich zwischen 800°C und 1050°C, der Gesamtdruck des Prozeßgases beträgt 10 - 15 bar. Die Temperzeit hängt von der gewünschten Extraktionstiefe ab; ein Beispiel wird im Beispiel 1 detaillierter erläutert. Ein charakteristisches Temperatur-ZeitProfil ist in Fig. 4. wiedergegeben. Hieraus ist ersichtlich, daß die Aufheiz- und Abkühlrate T-abhängig eingestellt wird.

Weitere Details der Erfindung werden aus den folgenden Beispielen ersichtlich.

1. Beispiel

Ein SI VGF-GaAs-Kristall mit einem Ziel-Durchmesser von 100 mm wurde mit der von Th. Bünger, D. Behr, St. Eichler, T. Flade, W. Fliegel, M. Jurisch, A. Kleinwechter, U. Kretzer, Th. Steinegger, B. Weinert, Mat. Sci. Technol. B80 (2001), 5 detaillierter beschriebenen Variante des VGF-Verfahrens gezüchtet und nach der Wärmebehandlung, dem Cropping, Rundschleifen, Flatten und der Probenentnahme zur Charakterisierung des Ausgangszustandes mittels Innenlochsägens zu Wafern mit der Standarddicke $d_o = (725 \pm 8)$ μm verarbeitet. Die Wafer wurden gemäß Standardtechnologie kantenverrundet, reinigungsgeätzt, gewaschen, getrocknet und bis zum Einbau unter einer nichtoxidierenden Atmosphäre ($N_2$) gelagert.

Der Einbau der Wafer in die erfindungsgemäßen Kassetten (100 mm ∅) erfolgte in einer Laminarbox. Alle Kassetten der Vorrichtung wurden mit Wafern (z. T. Dummy-Wafern) belegt. Der Freiraum oberhalb der Wafer betrug 0.3 mm.

Die gestapelten Kassetten wurden in der beschriebenen Weise zu einem Tempereinsatz komplettiert und in vertikaler Ausrichtung in einem Temperofen mit 3 unabhängig steuerbaren Heizern eingebaut. Der Druckrezipient wurde 3x abwechselnd evakuiert (jeweiliges Endvakuum: ≤ $10^{-3}$ mbar) und anschließend mit Reinststickstoff bis zu einem Druck von 13 bar (bei der jeweiligen Tempertemperatur) gefüllt. Die letzte Füllung erfolgte mit Reinststickstoff, dem 1 Vol.% $H_2$ zugesetzt wurden. Getempert wurde jeweils bei 950, 1000, 1050 und 1140°C Solltemperatur mit einer Haltezeit von jeweils 5 h. Die Aufheizrate betrug bis 400°C 40 K/min, darüber wurde bis zur Solltemperatur die Rate linear mit der Zeit bis auf 0 K/min bei Erreichen der Solltemperatur reduziert. In entsprechender Weise wurde auf Raumtemperatur abgekühlt.

Eine Oxidschichtbildung und damit eine ggf. mögliche Inhibierung der As-Desorption während der Wärmebehandlung wird durch die Zugabe von Wasserstoff unterbunden. Infolge der durch Wasserstoff erhöhten Oberflächendiffusion unterbleibt eine Aggregation von überschüssigem Gallium zu Tröpfchen. Die Rauhigkeit der Waferoberfläche nach dem Tempern ist im Vergleich zu der einer gesägt/geätzten Oberfläche signifikant verbessert.

Die getemperten Wafer wurden anschließend nach Standardtechnologie weiterverarbeitet, nämlich lasermarkiert, damagegeätzt und doppelseiting vorpoliert und einseitig (Frontseite) endpoliert. Hierbei wird die Dicke der jeweils abgetragenen oberflächenparallelen Schicht bestimmt.

Die Größenverteilung der As-Ausscheidungen nach dem Wafertempern wurde mit der bekannten Methode der Laser Scattering Tomographie (LST, vgl. hierzu M. Naumann, J. Donecker, M.Neubert: Laser scattering experiments in VCz GaAs, J. Cryst. Growth 210 (2000) 203) in sogenannter Kantenansicht untersucht, d. h. es wird ein kantennaher Bereich der Waferoberfläche beleuchtet und das aus der Bruchkante austretende Streulicht gemessen. In Fig. 5 sind Beispiele für einen Waferbereich mit Matrixpräzipitaten (links) und Dekorationspräzipitaten (rechts) wiedergegeben. Die Frontseite des Wafers weist noch oben.

Die Waferoberflächen sind durch die gestrichelten Linien gekennzeichnet. In einem oberflächenparallelen Bereich Δ sind keine Matrixpräzipitate zu erkennen. Auch die Streuintensität der Dekorationspräzipitate hat in einem, dem Bereich Δ entsprechenden Bereich im wesentlichen gleicher Dicke signifikant abgenommen. Folglich wurden die As-Ausscheidungen durch die Wärmebehandlung mit As-Extraktion aufgelöst bzw. ihre Größenverteilung hat sich zu kleineren Abmessungen verschoben. Verknüpft hiermit hat sich die Anzahl der COP's auf der Waferoberfläche im Vergleich zum Ausgangszustand signifikant reduziert.

Aus der gut meßbaren Tiefe Δ des As-ausscheidungsfreien Bereichs wurde ein die As-Extraktion kennzeichnender Transportkoeffizient abgeschätzt, der in Fig. 6 über der reziproken Tempertemperatur dargestellt ist. Hieraus kann für die gewünschte Extraktionstiefe bei vorgegebener Temperatur die erforderliche Haltezeit abgeschätzt werden. Bezüglich einer gut anwendbaren Berechnungsformel wird auf die obige Beschreibung verwiesen. Beispielsweise beträgt für eine mittlere Extraktionstiefe von 70 μm bei 980°C die nötige Haltezeit 4 h. Für Entfernungen von der Waferoberfläche, die größer als die mittlere Extraktionstiefe sind, wächst die mittlere Größe der As-Ausscheidungen rasch auf die für ungetemperte Wafer charakteristische Größe an.

An keilgeätzten Proben aus getemperten Wafern wurde festgestellt, daß eine von der mittleren Extraktionstiefe mit verringerter Größe der As-Ausscheidungen abhängende oberflächennahe Schicht der getemperten Wafer durch Verringerung der EL2-Konzentration p-leitend ist. Bei einer mittleren Extraktionstiefe von 70 μm beträgt die Dicke der p-leitenden Schicht ca. 20 μm. Der hieran anschließende von der As-Extraktion ebenfalls noch betroffene Dickenbereich des getemperten Wafers bleibt semi-isolierend (SI). Die p-leitende Schicht wird durch das Damageätzen und das Vorpolieren der getemperten Wafer zuverlässig entfernt.

Eine Beurteilung der strukturellen Perfektion der getemperten Wafer an Hand der Versetzungsätzpitdichte, des spannungsoptisch bestimmten Restspannungsgehaltes und der mittels Doppelkristall-Rockingkurvenmappings ermittelten Halbwertsbreite offenbarte keinerlei Unterschiede zu den entsprechenden Ergebnissen an kristallgetemperten Wafern.

2. Beispiel

Ungetemperte, rundgeschliffene und mit einem Notch versehene SI VGF-GaAs-Einkristalle mit einem Durchmesser von 152 mm wurden mittels Drahtläppens zu Wafern mit einer mittleren Dicke (774 ± 8) μm aufgearbeitet. Die Wafer wurden reinigungs- und damagegeätzt und wie im 1. Beispiel beschrieben in die erfindungsgemäßen Kassetten mit einem Innendurchmesser von ca. 153 mm und einer Höhe des Freiraumes über den Wafern von 0.4 mm eingebaut. Die Wärmebehandlung erfolgte bei 980°C mit einer Haltezeit von 4 h. Aufheiz- und Abkühlrate waren mit den im 1. Beispiel genannten Werten identisch. Der Arbeitsdruck des $N_2/H_2$-Prozeßgases bei Solltemperatur betrug 12 bar, der Wasserstoffgehalt 1 Vol.%.

Die getemperten Wafer sowie Vergleichswafer aus denselben Kristallen wurden kantenverrundet, lasermarkiert, damagegeätzt sowie doppelseitig vorpoliert und einseitig endpoliert sowie endgereinigt. Die Fertigdicke der Wafer betrug (690 ± 5) μm und lag somit an der oberen Toleranzgrenze für Wafer mit 150 mm Durchmesser. Anschließend wurden nach Standardvorschriften unter Verwendung des Surfscan 6420 (KLA-Tencor) über eine Bestimmung der sogenannten "light point defects" (Ipd) die Anzahl COP's im Größenklassenbereich (0.2 - 2.0) μm bzw. (0.3 - 2.0) μm sowie unter Verwendung des SUPERSORT™ die geometrischen Kenngrößen der Wafer gemessen.

In Tab. 1 ist die mittlere Anzahl der COP's nach dem Wafertempern mit derjenigen von Vergleichswafern, die herkömmlich einer Kristalltemperung unterzogen wurden, verglichen. Es ist ersichtlich, daß durch das Wafertempern die Anzahl COP's um mehr als eine Größenordnung in den jeweiligen Größenbereichen verringert wurde. Im Unterschied zum Ausgangsmaterial ist die Häufigkeitsverteilung nach dem Wafertempern sehr schmal, was eine sehr gut Reproduzierbarkeit und Zuverlässigkeit des erfindungsgemäßen Extraktionsprozesse zur Kontrolle der As-Ausscheidungen anzeigt.

Tab. 1: "light point defects" (Ipd) nach Kristall- und Wafertempern

|  | Ipd (0.2 - 2) μm Anzahl/cm² | Ipd (0.3 - 2) μm Anzahl/cm² |
|---|---|---|
| Kristalltemperung | 80,4 ± 17,2 | 11,2 ± 8,4 |
| Wafertemperung | 3,3 ± 2,4 | 0,12 ± 0,08 |

Die getemperten Wafer wurden ein 2. Mal doppelseitig vorpoliert und einseitig endpoliert und erneut vermessen. Ihre Dicke lag nun im Bereich der unteren Toleranzgrenze von (655 ± 5) μm. Die Anzahl der COP's auf der Waferoberfläche war größer als nach dem 1. Polierschritt, lag jedoch weiter unter der Spezifikationsgrenze. Durch Wahl der Extraktionstiefe ist es somit möglich, die Anzahl der COP's im gesamten zulässigen Dickenbereich der Wafer unter die jeweiligen Spezifikationsgrenzen abzusenken.

Die Ergebnisse der Messung der geometrischen Kenngrößen der Wafer sind in Tab. 2 wiedergegeben. Es werden keine signifikanten Unterschiede gefunden. Somit führt das Tempern in den erfindungsgemäßen Kassetten zu keiner Verschlechterung der geometrischen Parameter der Wafer im Vergleich zur konventionellen Verfahrensweise.

Tab. 2: Geometrieparameter nach Kristall- und Wafertempern

|  | ttv/μm | ltv/μm | sori/μm | warp/μm | bow/μm |
|---|---|---|---|---|---|
| Kristalltemperung | 1,27 ± 0,46 | 0,74 ± 0,27 | 2,38 ± 1,48 | 2,55 ± 1,61 | 0,24 ± 0,53 |

(fortgesetzt)

|  | ttv/$\mu$m | ltv/$\mu$m | sori/$\mu$m | warp/$\mu$m | bow/$\mu$m |
|---|---|---|---|---|---|
| Wafertemperung | 2,06 $\pm$ 1,15 | 1,21 $\pm$ 0,66 | 2,90 $\pm$ 1,84 | 3,10 $\pm$ 2,59 | 1,01 $\pm$ 1,44 |

Zur Beurteilung der Homogenität bauelementerelevanter Eigenschaften wurde an den getemperten Wafern beispielhaft die EL2°-Konzentration auf einem Streifen mit einer Breite von 7,5 mm längs eines Waferradius (0 - $R_W$) in <110>-Richtung mit der lateralen Auflösung von ca. 30 $\mu$m bzw. 270 $\mu$m quer bzw. parallel zum Streifen gemessen. Die Messungen erfolgten mit der bekannten Methode der Absorption im nahen Infrarot bei $\lambda$ = 1064 nm unter Verwendung der Photoionisationsquerschnitte von Silverberg et al. (P. Silverberg, P. Omeling, L. Samuelson: Appl. Phys. Lett. 52 (1988)1689). Desweiteren wurden Ganzwafermappings des spezifischen elektrischen Widerstandes mit einer Auflösung von 1,0 mm mittels der TDCM-Methode gemäß R. Stibal et al. (R. Stibal, J. Windscheif, W. Jantz: Contactless evaluation of semi-insulating GaAs wafer resistivity using the time dependent charge measurement, Semicond. Sci. Technol. 6 (1991)995-1001) gemessen.

Die mittlere EL2°-Konzentration der Wafer wird durch das erfindungsgemäße Wafertempern um ca. 30 % auf 1,40x10^{16}cm^{-3} im Vergleich zu Wafern aus Kristallen nach Standard-Kristalltemperung erhöht. Wie aus Tab. 3 ersichtlich ist, verringert sich die relative Standardabweichung der mittleren EL2°-Konzentration von 12 - 16 % auf 4 - 5 % nach dem Wafertempern. Die mesoskopische Homogenität der EL2°-Verteilung (siehe hierzu: M. Wickert: "Physikalische Mechanismen der Homogenisierung elektrischer Eigenschaften von GaAs-Substraten", Dissertation, Albert-Ludwigs-Universität Freiburg im Breisgau, 1998), die nach dem Kristalltempern ca. 9 % betrug verbesserte sich auf ca. 4 % durch das Wafertempern.

Der prozentualen Erhöhung der EL2°-Konzentration entsprechend verringerte sich der mittlere spezifische Widerstand der Wafer. Analog äußerte sich die verbesserte EL2°-Homogenität der getemperten Wafer in einer verbesserten makroskopischen und mesoskopischen Homogenität des Widerstandes.

Tab. 3: EL2°-Verteilung nach Kristall- und Wafertempern

|  | RSTD/% | $\sigma_{mesos}$/% |
|---|---|---|
| Kristalltemperung | 12,3 $\pm$ 8,7 | 9.0 $\pm$ 2.4 |
| Wafertemperung | 4,2 $\pm$ 0,8 | 3,8 $\pm$ 0,6 |

Zur Beurteilung der strukturellen Perfektion der getemperten Wafer wurde die Versetzungsätzpitdichte nach Standard-KOH-Ätze und Auswertung von Ganzwafer-Mappings bestimmt und die mittlere Halbwertsbreite von {004}-Cu-$K_\alpha$ Doppelkristall-Rockingkurven-Mappings mit <110>-Rockingache und 1x1 mm$^2$ Schrittweite sowie 1x2 mm$^2$ Meßfleckgröße ermittelt. Ergebnisse dieser Untersuchungen sind in Tab. 4 enthalten.

Tab. 4: EPD und Rockingkurven-Halbwertsbreite

|  | epd / cm$^{-2}$ | FWHM$_{mean}$/arcsec |
|---|---|---|
| Kristalltemperung | 6840 $\pm$ 1250 | 10.41 $\pm$ 0.88 |
| Wafertemperung | 5600 $\pm$ 1020 | 10.83 $\pm$ 0.20 |

Es wurden keine signifikanten Unterschiede zu den entsprechenden Ergebnissen an kristallgetemperten Wafern gefunden, d. h. die strukturelle Perfektion der getemperten Wafer wird durch die erfindungsgemäße Wärmebehandlung in der erfindungsgemäßen Tempervorrichtung nicht verändert.

3. Beispiel

Drei ungetemperte und drei kristallgetemperte SI VGF-GaAs Einkristalle mit einem Ziel-Durchmesser von jeweils 150 mm wurden nach dem Cropping und Rundschleifen mittels Drahtläppens zu Wafern mit einer mittleren Dicke (770 $\pm$ 8) $\mu$m aufgearbeitet. Die Wafer wurden reinigungs- und damagegeätzt und wie im 1. Beispiel beschrieben in die erfindungsgemäßen Kassetten mit einem Innendurchmesser von ca. 153 mm und 0.4 mm Höhe des Freiraumes eingebaut. Die Wärmebehandlung erfolgte bei 980°C mit einer Haltezeit von 4 h. Aufheiz- und Abkühlrate sind mit den im 1. Beispiel genannten Werten identisch. Der Arbeitsdruck des $N_2$/$H_2$-Prozeßgases bei Solltemperatur betrug 11- 13 bar, der Wasserstoffgehalt 1 Vol.%.

Die getemperten Wafer wurden nach Standardprozedur kantenverrundet, lasermarkiert, damagegeätzt sowie doppelseitig vor- und einseitig endpoliert sowie endgereinigt. Ein Teil der Wafer wurde ein 2. Mal doppelseitig vor- und einseitig endpoliert.

An diesen Wafern wurde nach der Bestimmung der Anzahl der COP's die Bruchfestigkeit gemessen. Die Messungen erfolgten unter Verwendung des von SCHAPER et al. (M. Schaper, M. Jurisch, H.-J. Klauß, H. Balke, F. Bergner, R. Hammer, M. Winkler: Fracture Strength of GaAs Wafers, in B. Michel, T. Winkler, M. Werner, H. Fecht (Eds.): Proceedings 3rd Internat. Conf. MircoMat 2000, 17. - 19. 04. 2000, Berlin) näher beschriebenen modifizierten Doppelringversuch. Der Stützring mit einem Innendurchmesser von 142 mm bestand aus PTFE, die Last wurde über eine Stahlkugel mit 1/8" im Waferzentrum aufgebracht. Jeweils die endpolierten Frontseiten der Wafer wurden auf Zug belastet. Die Last-Durchbiegungs-Kurven wurden bis zum Bruch registriert. Prüfergebnis ist das Wertepaar Bruchlast/maximale Durchbiegung (F.max, f). Die Meßergebnisse wurden auf eine einheitliche Waferdicke von 675 $\mu$m normiert. Diese Normierung wie auch die Berechnung der Bruchfestigkeit aus der Bruchlast erfolgten auf der Grundlage der theoretischen Analyse des Bruchtests von F. DUDERSTADT (F. Duderstadt: "Anwendung der von Karman'schen Plattentheorie und der Hertz'schen Pressung für die Spannungsanalyse zur Biegung von GaAs-Wafern im modifizierten Doppelringtest", PhD thesis, TU Berlin, 2003).

Die charakteristischen Bruchfestigkeiten der Wafer nach dem Wafertempern im Vergleich zu den entsprechenden Ergebnissen an Wafern aus kristallgetemperten SI VGF GaAs-Einkrstallen sind in Tab. 5 wiedergegeben.

Tab. 5: Bruchfestigkeit der Wafer nach Kristall- und Wafertempern

|  | $\sigma_c$ / MPa |
|---|---|
| Kristalltemperung | 1475 $\pm$ 155 |
| Wafertemperung | 2060 $\pm$ 150 |

Die charakteristische Bruchfestigkeit der getemperten Wafer ist signifikant größer als die von kristallgetemperten Wafern. Als Ursache für diesen Unterschied wird die durch das Wafertempern im oberflächennahen Bereich verringerte mittlere Größe der As-Auscheidungen und die hieraus folgende geringere mittlere Größe der COP's auf der Waferoberfläche im Vergleich zum kristallgetemperten Material angesehen. Offensichtlich wirken die COP's als Keime für die Initüerung des Bruchvorganges..

*Vergleichswafer*

Die zum Vergleich herangezogenen Wafer wurden aus SI VGF GaAs-Einkristallen nach einer Kristalltemperung gefertigt. Die Temperung erfolgte in Quarzampullen unter einem As-Partialdruck von 1 bar bei 800°C mit einer Haltzeit von 10 h. Die Aufheiz- und Abkühlrate betrug 0,5 K/min oberhalb 400°C.

Die Erfindung ist nicht beschränkt auf die speziellen Beispiele; diese haben lediglich beispielhaften Charakter und dienen zur Erläuterung.

**Patentansprüche**

1. Vorrichtung mit einem Wafer, wobei die Vorrichtung zum Wärmebehandeln des Wafers bei erhöhter Temperatur dient, wobei der Wafer mindestens an der Waferoberfläche ein III-V-Halbleitermaterial umfasst, **dadurch gekennzeichnet, daß** sie mindestens eine

   Wafer-Trägereinheit (10) mit einem Wafer aufweist, die in ihrer Dimension so bemessen ist, daß,
   nach Auflage des zu tempemden Wafers auf dem Träger,
   die zu behandelnde, das III-V-Halbleitermaterial umfassende Oberfläche

   - entweder direkt durch ein gaspermeables und/oder poröses Material bedeckt ist,
   - oder durch ein Material, das gaspermeabel und/oder porös ist oder nicht, bei einem Abstand von über 0 mm bis maximal 2 mm überdeckt ist.

2. Vorrichtung nach Anspruch 1, wobei die Wafer-Trägereinheit mit der Decke einen den Wafer aufnehmenden, begrenzten Raum derart bildet, daß ein ungehinderter freier Gaszutritt zu den Waferoberflächen nicht, ein begrenzter Gasaustausch nach außerhalb der Wafer-Trägereinheit jedoch möglich ist.

3. Vorrichtung nach Anspruch 1 oder 2, wobei sie eine Mehrzahl von Wafer-Trägereinheiten (10) aufweist, die in Kassettenform so stapelbar sind, daß eine Wafer-Trägereinheit einen Auflageboden für einen ersten (n-ten) Wafer aufweist und die darauf gestapelte Wafer-Trägereinheit für einen darüberliegenden zweiten ((n+1)-ten) Wafer die höhenbegrenzende, vollständige Abdeckung für den Raum des ersten (n-ten) Wafers bildet.

4. Vorrichtung nach einem der vorangehenden Ansprüche, **dadurch gekennzeichnet, daß** die Wafer-Trägereinheit (10) einen Auflageboden aufweist, der mindestens teilweise oder vollständig aus einem gaspermeablen und/oder porösen Material gefertigt ist.

5. Vorrichtung nach einem der vorangehenden Ansprüche, wobei der Träger, auf dem der zu tempernde Wafer aufliegt, einen durchgängig ebenen Boden aufweist, der vorzugsweise aus einem Material hoher Wärmeleitfähigkeit gefertigt ist.

6. Vorrichtung nach einem der vorangehenden Ansprüche, **dadurch gekennzeichnet, daß** die Wafer-Trägereinheit (10) einen geschlossenen Raum bildet und ein Diffusionshindernis (16) aufweist, die das durch den geschlossenen Raum gebildete Mikrovolumen vom Außenraum abschließt.

7. Vorrichtung nach einem der vorangehenden Ansprüche, **dadurch gekennzeichnet, daß** sie keine Bauteile aus Quarzglas aufweist.

8. Verfahren zur Wärmebehandlung von Wafern, die ein III-V-Halbleitermaterial umfassen, bei erhöhter Temperatur, **dadurch gekennzeichnet, daß** die Wafer, die mittels Trennens aus as-grown III-V-Einkristallen mit einem Durchmesser von $\geq 100$ mm hergestellt wurden, in einem Zustand wärmebehandelt werden, bei dem eine zu behandelnde, das III-V-Halbleitermaterial umfassende Oberfläche

   - entweder direkt durch ein gaspermeables und/oder poröses Material bedeckt wird, oder
   - durch ein Material, das gaspermeabel und/oder porös ist oder nicht, bei einem Abstand von über 0 mm bis maximal 2 mm überdeckt wird.

9. Verfahren nach Anspruch 8, **dadurch gekennzeichnet, daß** die Wafer, die mittels Trennens aus as-grown III-V-Einkristallen mit einem Durchmesser von $\geq 100$ mm hergestellt wurden, nach einem Schritt zum Reinigen und Ätzen und vor einem Schritt zum Kantenverrunden in einer quarzfreien Wärmebehandlungsvorrichtung, die mindestens eine Wafer-Trägereinheit (10) aufweist, wärmebehandelt werden.

10. Verfahren nach Anspruch 8 oder 9, wobei Wafer in die Vorrichtung gemäß einem der Ansprüche 1 bis 7 so eingelegt werden, daß die das III-V-Halbleitermaterial umfassenden Frontseiten der Wafer in den durch die Deckelauflage größen-definierten Raum zeigen.

11. Verfahren nach einem der Ansprüche 8 bis 10, wobei Wafer verwendet werden, die einkristallines GaAs umfassen.

12. Verfahren nach einem der Ansprüche 8 bis 11, wobei die Wafer aus nach dem VGF- oder dem VB-Verfahren gezüchteten Einkristallen hergestellt wurden.

13. Verfahren nach einem der Ansprüche 8 bis 12, **dadurch gekennzeichnet, daß** der Tempervorgang der Wafer nur einmal durchgeführt wird.

14. Verfahren nach einem der Ansprüche 8 bis 13, **dadurch gekennzeichnet, daß** die Wärmebehandlung der Wafer im Temperaturbereich von 750 - 1150°C unter einer Inertgas-Atmosphäre mit einem Wasserstoffgehalt von mind. 0,5 Vol. % und einem Gesamtdruck von 10-20 bar erfolgt.

15. Verfahren nach einem der Ansprüche 8 bis 14, **dadurch gekennzeichnet, daß** das III-V-Halbleitermaterial III-As ist, und daß außerhalb der Wafer-Trägereinheit kein As-Partialdruck durch die Verdampfung von festem Arsen oder auf eine andere Weise erzeugt wird.

16. Verfahren nach einem der Ansprüche 8 bis 15, **dadurch gekennzeichnet, dass** das III-V-Halbleitermaterial III-As ist, und daß die Haltezeit bei der Tempertemperatur so bestimmt wird, daß eine As-Extraktionstiefe mindestens 20 $\mu$m beträgt.

17. Verfahren nach einem der Ansprüche 8 bis 16, wobei die EL2°- Konzentration von as-grown VB/VGF-Wafern mit einer Versetzungsdichte < $1 \times 10^4$ cm$^{-2}$ um mindestens 30 % erhöht wird.

**18.** GaAs-Halbleitereinkristallwafer mit einem Durchmesser von ≥100 mm und einer Versetzungsdichte von ≤ 1 x 10$^4$ cm$^{-2}$, **dadurch gekennzeichnet, daß** die charakteristische Bruchfestigkeit, bis zu der 63,2 % (Weibull-Verteilung) der Wafer ausgefallen sind, gegenüber derjenigen für SI GaAs Wafer aus kristallgetempertem Material um mindestens 25 % größer ist.

**19.** GaAs-Halbleitereinkristallwafer mit einem Durchmesser von ≥ 100 mm und einer Versetzungsdichte von ≤ 1 x 10$^4$ cm$^{-2}$, **dadurch gekennzeichnet, daß** die charakteristische Bruchfestigkeit, bis zu der 63,2 % (Weibull-Verteilung) der Wafer ausgefallen sind, größer ist als 1900 MPa.

**20.** GaAs-Halbleitereinkristallwafer gemäß Anspruch 18 oder 19, mit einer zusätzlichen Kombination mit mindestens einem der folgender Merkmale:

- einer Konzentration an anderen Verunreinigungen als Kohlenstoff und Bor von insgesamt ≤ 5x10$^{-4}$ cm$^{-3}$,
- |Δ[EL2°]/[EL2°]| ≤ 7,5 % und σmesos ≤ 6 %
- lpd(0.3 - 2.0 μm) < 0,3 cm$^{-2}$.

**21.** GaAs-Halbleitereinkristallwafer gemäß einem der Ansprüche 18 bis 20, **dadurch gekennzeichnet, daß** er nach einem Verfahren gemäß irgendeinem der Ansprüche 8 bis 17 erhältlich ist.

**Claims**

**1.** A device including a wafer, wherein the device is for heat treating a wafer at an increased temperature, wherein the wafer comprises a III-V semiconductor material at least at a surface thereof, **characterized in that** it comprises at least one wafer support unit (10) including a wafer, which wafer support unit is defined in its dimensions such that, after laying the wafer to be annealed onto the support, the surface to be treated comprising the III-V semiconductor material

- is either directly covered by a gas-permeable and/or porous material, or
- is covered by a material, which is gas-permeable and/or porous or not, at a distance of more than 0 mm to maximally 2 mm.

**2.** The device according to claim 1, wherein the wafer support unit forms, together with the cover, a defined space for housing the wafer in such a manner that an unhindered free gas access to the wafer surfaces is not possible, but a limited gas exchange to the outside of the wafer support unit is possible.

**3.** The device according to claim 1 or 2, which comprises a multitude of wafer support units (10), which can be stacked in cassette form such that a wafer support unit comprises a support bottom for a first (n$^{th}$) wafer, and that the wafer support unit stacked thereupon for an overlaying second ((n+1)$^{th}$) wafer forms the height-limiting, complete cover for the space of the first (n$^{th}$) wafer.

**4.** The device according to one of the preceding claims, **characterized in that** the wafer support unit (10) comprises a support bottom which is, at least partially or completely, made of a gas-permeable and/or porous material.

**5.** The device according to one of the preceding claims, wherein the support, on which the wafer to be annealed lays, has a continuous flat bottom which is preferably made of a high thermal conductivity material.

**6.** The device according to one of the preceding claims, **characterized in that** the wafer support unit (10) forms a closed space and comprises a diffusion barrier (16) which closes the micro volume formed by the closed space to the outside.

**7.** The device according to one of the preceding claims, **characterized in that** it does not comprise components made of quartz glass.

**8.** A process for heat treating, at increased temperature, wafers comprising a III-V semiconductor material, **characterized in that** the wafers, which had been prepared by separation from as-grown III-V single crystals having a diameter of ≥ 100 mm, are heat treated in a status wherein a surface to be treated and comprising the III-V semiconductor material

- is either directly covered by a gas-permeable and/or porous material, or
- is covered by a material, which is gas-permeable and/or porous or not, at a distance of more than 0 mm to maximally 2 mm.

9. The process according to claim 8, **characterized in that** the wafers, which had been prepared by separation from as-grown III-V single crystals having a diameter of $\geq 100$ mm, are heat treated after a step for purifying and etching and before a step for edge-grinding, in a heat treatment device free of quartz, which device comprises at least one wafer support unit (10).

10. The process according to claim 8 or 9, wherein the wafer is placed into the device according to one of claims 1 to 7 such that the front sides of the wafers comprising the III-V semiconductor material face to the space which is defined in size by the overlay of the cover.

11. The process according to one of claims 8 to 10, wherein wafers are used which comprise single crystalline GaAs.

12. The process according to one of claims 8 to 11, wherein the wafers had been prepared from single crystals grown by VGF or VB process.

13. The process according to one of claims 8 to 12, wherein the annealing process of the wafers is carried out only once.

14. The process according to one of claims 8 to 13, **characterized in that** the heat treatment of the wafers is carried out in a temperature range of 750-1150°C under inert gas atmosphere with a hydrogen content of at least 0.5 vol. % and a total pressure of 10-20 bar.

15. The process according to one of claims 8 to 14, **characterized in that** the III-V semiconductor material is III-As, and that no As partial pressure is generated outside the wafer support unit by evaporating solid arsenic or in any other manner.

16. The process according to one of claims 8 to 15, **characterized in that** the III-V semiconductor material is III-As, and that the time for maintaining the annealing temperature is determined such that an As extraction depth is at least about 20 $\mu$m.

17. The process according to one of claims 8 to 16, wherein the EL2° concentration of as-grown VB/VGF wafers having a dislocation density of $< 1 \times 10^4$ cm$^{-2}$ is increased by at least 30%.

18. A GaAs semiconductor single crystal wafer having a diameter of $\geq 100$ mm and a dislocation density of $\leq 1 \times 10^4$ cm$^{-2}$, **characterized in that** the characteristic fracture strength, up to which 63.2% (Weibull distribution) of wafers have failed, is by at least 25% higher than that of SI GaAs wafers from crystal annealed material.

19. A GaAs semiconductor single crystal wafer having a diameter of $\geq 100$ mm and a dislocation density of $\leq 1 \times 10^4$ cm$^{-2}$, **characterized in that** the characteristic fracture strength, up to which 63.2% (Weibull distribution) of wafers fail, is higher than 1900 MPa.

20. The GaAs semiconductor single crystal wafer according to claim 18 or 19, further combined with at least one of the following features:

- a concentration of impurities other than carbon and boron of $\leq 5 \times 10^{14}$ cm$^{-3}$ in total,
- $|\Delta[EL2°]/[EL2°]/[EL2°]| \leq 7.5\%$ 5% $\sigma$mesos $\leq 6$ %
- 1pd (0.3- 2.0 $\mu$m) < 0.3 cm$^{-2}$.

21. The GaAs semiconductor single crystal wafer according to one of claims 18 to 20, **characterized in that** it is obtainable by a process according to any one of claims 8 to 17.

**Revendications**

1. Dispositif avec une plaquette, ledit dispositif servant au traitement thermique à température élevée de la plaquette, ladite plaquette comprenant au moins un matériau semi-conducteur de type III-V, **caractérisé en ce qu'**il comporte au moins une

unité de support de plaquette (10) avec une plaquette, dimensionnée de telle manière qu'après application de la plaquette à recuire sur le support, la surface à traiter comprenant le matériau semi-conducteur de type III-V

- est soit directement couverte par une matière perméable aux gaz et/ ou poreuse,
- soit recouverte par une matière qui est perméable aux gaz et/ou poreuse ou bien ne l'est pas, avec un espacement de plus de 0 mm à 2 mm au maximum.

2. Dispositif selon la revendication 1, où l'unité de support de plaquette forme avec la couverture un espace limité recevant la plaquette, de manière à ne pas rendre possible un accès gazeux libre et sans obstacle vers la surface de la plaquette, mais un échange gazeux limité vers l'extérieur de l'unité de support de plaquette.

3. Dispositif selon la revendication 1 ou la revendication 2, comportant une pluralité d'unités de support de plaquette (10), lesquelles sont empilables en forme de cassette de telle manière qu'une unité de support de plaquette présente un plateau d'appui pour une première ($n^{ième}$) plaquette, et que l'unité de support pour une deuxième (($n+1)^{ième}$) plaquette superposée forme la couverture intégrale, limitatrice de hauteur pour l'espace de la première ($n^{ième}$) plaquette.

4. Dispositif selon l'une des revendications précédentes, **caractérisé en ce que** l'unité de support de plaquette (10) présente un plateau d'appui qui est au moins partiellement ou totalement fabriqué dans une matière perméable aux gaz et/ ou poreuse.

5. Dispositif selon l'une des revendications précédentes, où le support sur lequel repose la plaquette à recuire présente un plateau plan continu fabriqué de préférence dans une matière à conductivité thermique élevée.

6. Dispositif selon l'une des revendications précédentes, **caractérisé en ce que** l'unité de support de plaquette (10) forme un espace clos et présente un obstacle à la diffusion (16) qui sépare de l'espace extérieur le micro-volume formé par l'espace clos.

7. Dispositif selon l'une des revendications précédentes, **caractérisé en ce qu'**il ne comprend aucun composant en verre de quartz.

8. Procédé de traitement thermique à température élevée de plaquettes comprenant un matériau semi-conducteur de type III-V, **caractérisé en ce que** les plaquettes fabriquées par séparation de monocristaux III-V as-grown d'un diamètre ≥ 100 mm, sont soumises à un traitement thermique dans un état où une surface à traiter comprenant le matériau semi-conducteur de type III-V

- est soit directement couverte par une matière perméable aux gaz et/ ou poreuse,
- soit recouverte par une matière qui est perméable aux gaz et/ou poreuse ou bien ne l'est pas, avec un espacement de plus de 0 mm à 2 mm au maximum.

9. Procédé selon la revendication 8, **caractérisé en ce que** les plaquettes fabriquées par séparation de monocristaux III-V as-grown d'un diamètre ≥ 100 mm, sont après une étape de nettoyage et de gravure chimique et avant une étape d'émoussement des arêtes traitées thermiquement dans un dispositif de traitement thermique exempt de quartz comportant au moins une unité de support de plaquette (10).

10. Procédé selon la revendication 8 ou la revendication 9, où les plaquettes sont mises en place dans le dispositif selon l'une des revendications 1 à 7, de telle manière que les faces frontales des plaquettes comprenant le matériau semi-conducteur de type III-V sont orientées vers l'espace de grandeur définie par l'application du couvercle.

11. Procédé selon l'une des revendications 8 à 10, où des plaquettes comprenant du GaAS monocristallin sont utilisées.

12. Procédé selon l'une des revendications 8 à 11, où les plaquettes sont fabriquées à partir de monocristaux élaborés suivant le procédé VGF ou le procédé VB.

13. Procédé selon l'une des revendications 8 à 12, **caractérisé en ce que** le recuit des plaquettes n'est effectué qu'une fois.

**14.** Procédé selon l'une des revendications 8 à 13, **caractérisé en ce que** le traitement thermique des plaquettes a lieu dans une plage de température comprise entre 750 et 1150 °C sous une atmosphère gazeuse inerte avec une teneur en hydrogène minimale de 0,5 vol. % et une pression totale de 10 à 20 bar.

**15.** Procédé selon l'une des revendications 8 à 14, **caractérisé en ce que** le matériau semi-conducteur de type III-V est le III-As, et **en ce qu'**aucune pression partielle d'As n'est générée par la vaporisation d'arsenic solide ou d'une autre manière à l'extérieur de l'unité de support de plaquette.

**16.** Procédé selon l'une des revendications 8 à 15, **caractérisé en ce que** le matériau semi-conducteur de type III-V est le III-As, et **en ce que** le temps de maintien à température de recuit est déterminé de telle manière qu'une profondeur d'extraction As soit de 20 $\mu$m au moins.

**17.** Procédé selon l'une des revendications 8 à 16, où la concentration EL2° de plaquettes VB/VGF as-grown avec une densité de dislocations $< 1 \times 10^4$ cm$^{-2}$ est accrue d'au moins 30 %.

**18.** Plaquette semi-conductrice à monocristaux de GaAs avec un diamètre $\geq$ 100 mm et une densité de dislocations $\leq 1 \times 10^4$ cm$^{-2}$, **caractérisée en ce que** la résistance à la rupture caractéristique à laquelle environ 63,2 % (distribution de Weibull) des plaquettes sont détruites, est accrue d'au moins 25 % par rapport à celle d'une plaquette SI GaAS en matière à cristaux recuits.

**19.** Plaquette semi-conductrice à monocristaux de GaAs avec un diamètre $\geq$ 100 mm et une densité de dislocations $\leq 1 \times 10^4$ cm$^{-2}$, **caractérisée en ce que** la résistance à la rupture caractéristique, à laquelle environ 63,2 % (distribution de Weibull) des plaquettes sont détruites, est supérieure à 1900 MPa.

**20.** Plaquette semi-conductrice à monocristaux de GaAs selon la revendication 18 ou la revendication 19, avec une combinaison complémentaire comportant au moins une des caractéristiques suivantes :

- une concentration totale d'impuretés autres que le carbone et le bore $\leq 5 \times 10^{14}$ cm$^{-3}$,
- $|\Delta[EL2°]/[EL2°]| \leq 7,5$ % et $\sigma$mesos $\leq 6$ %
- Ipd(0.3-2.0 $\mu$m) $< 0,3$ cm$^{-2}$.

**21.** Plaquette semi-conductrice à monocristaux de GaAs selon l'une des revendications 18 à 20, **caractérisée en ce qu'**elle est réalisée suivant un procédé selon l'une quelconque des revendications 8 à 17.

Fig. 1

Fig. 2

**Fig. 3**

**Fig. 4**

Fig. 5

Fig. 6

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 5219632 A
- EP 0399662 A
- JP 58143520 A
- JP 1927973 B
- US 5047370 A
- JP 4215439 A
- US 5137847 A
- JP 8255799 A
- JP 8259396 A
- JP 9194300 A
- JP 2002274999 A
- JP 2001135590 A
- JP 9199508 A
- JP 5082527 A
- JP 2000294561 A
- JP 6302532 A
- JP 10287500 A
- JP 10289883 A
- JP 10321540 A

### In der Beschreibung aufgeführte Nicht-Patentliteratur

- **D. RUMSBY ; R. M. WAFER ; B. SMITH ; M. TYJBERG ; M. R. BROZEL ; E. J. FOULKES.** Tech. Dig. GaAs IC Symp. *IEEE,* 1983, vol. 34
- **O. ODA ; H. YAMAMOTO ; K. KAINOSHO ; T. IMAIZUMI ; H. OKAZAKI.** Recent developments of bulk III-V materials: annealing and defect control. *Inst. Phys. Conf. Ser.,* 1993, 285-293
- Defect thermodynamics and phase diagrams in compound crystal growth processes. **H. WENZL ; W. A. OATES ; K. MIKA.** Handbook of Crystal Growth. 1993, vol. 1A
- **O. ODA ; H. YAMAMOTO ; K. KAINOSHO ; T. IMAIZUMI ; H. OKAZAKI.** Recent developments of bulk III-V materials: annealing and defect control. *Inst. Phys. Conf.,* 1993, 285-293
- **W. TIMISCHL.** Qualitätssicherung. Carl Hanser Verlag, 1996
- **TH. BÜNGER ; D. BEHR ; ST. EICHLER ; T. FLADE ; W. FLIEGEL ; M. JURISCH ; A. KLEINWECHTER ; U. KRETZER ; TH. STEINEGGER ; B. WEINERT.** *Mat. Sci. Technol.,* 2001, vol. B80
- **M. NAUMANN ; J. DONECKER ; M.NEUBERT.** Laser scattering experiments in VCz GaAs. *J. Cryst. Growth,* 2000, vol. 210, 203
- **P. SILVERBERG ; P. OMELING ; L. SAMUELSON.** *Appl. Phys. Lett.,* 1988, vol. 52, 1689
- **R. STIBAL ; J. WINDSCHEIF ; W. JANTZ.** Contactless evaluation of semi-insulating GaAs wafer resistivity using the time dependent charge measurement. *Semicond. Sci. Technol.,* 1991, vol. 6, 995-1001
- Fracture Strength of GaAs Wafers. **M. SCHAPER ; M. JURISCH ; H.-J. KLAUß ; H. BALKE ; F. BERGNER ; M. WINKLER.** Proceedings 3rd Internat. Conf. MircoMat 2000. 19. April 2000, vol. 17
- **F. DUDERSTADT.** Anwendung der von Karman'schen Plattentheorie und der Hertz'schen Pressung für die Spannungsanalyse zur Biegung von GaAs-Wafern im modifizierten Doppelringtest. *PhD thesis,* 2003